# EUROPÄISCHE PATENTSCHRIFT

(11) **EP 2 572 167 B1**
(45) Veröffentlichungstag und Bekanntmachung des Hinweises auf die Patenterteilung: **03.09.2014**
(21) Anmeldenummer: 11726333.5
(22) Anmeldetag: 18.05.2011
(51) Int. Cl.: G01R 33/10

(54) **VERFAHREN UND VORRICHTUNG ZUR ERMITTLUNG DER RÄUMLICHEN KOORDINATEN MINDESTENS EINES SENSORKNOTENS IN EINEM BEHÄLTNIS**
METHOD AND APPARATUS FOR DETERMINING THE SPATIAL COORDINATES OF AT LEAST ONE SENSOR NODE IN A CONTAINER
PROCÉDÉ ET DISPOSITIF PERMETTANT DE DÉTERMINER LES COORDONNÉES SPATIALES D'AU MOINS UN NOEUD CAPTEUR DANS UN CONTENANT

(30) Priorität: 18.05.2010 DE 102010020835
(43) Veröffentlichungstag der Anmeldung: 27.03.2013
(73) Patentinhaber: Technische Universität Kaiserslautern, 67663 Kaiserslautern (DE)
(72) Erfinder: KÖNIG, Andreas, 66851 Queidersbach (DE); CARRELLA, Stefano, 67705 Stelzenberg (DE); ISWANDY, Kuncup, 67655 Kaiserslautern (DE)
(74) Vertreter: Patentanwälte Dr. Keller, Schwertfeger
(86) Internationale Anmeldenummer: PCT/EP2011/002455
(87) Internationale Veröffentlichungsnummer: WO 2011/144325

(56) Entgegenhaltungen:
- WO-A1-00/17603
- WO-A1-94/04938

## Beschreibung

### Technisches Gebiet:

Die Erfindung betrifft ein Verfahren zur Ermittlung der räumlichen Koordinaten eines Sensorknotens in einem Behältnis gemäß den Merkmalen des Patentanspruchs 1 sowie einer Vorrichtung zur Durchführung eines solchen Verfahrens gemäß Patentanspruch 11.

### Stand der Technik:

Zur Überwachung einer vorgegebenen räumlichen Umgebung, beispielsweise einem Behälter oder Reaktor, ist der Einsatz von Sensometzen bekannt. Diese setzen sich aus einer Vielzahl von Sensorknoten zusammen, deren Aufgabe es ist, Messwerten wie zum Beispiel Druck, Temperatur, pH-Wert, Stoffkonzentrationen und dergleichen zu erfassen und diese verarbeitet oder unverarbeitet zur Auswertung weiterzuleiten. Ein bevorzugtes Anwendungsgebiet stellt beispielsweise die industrielle Verfahrenstechnik dar, wo zur Regelung vieler Verfahrensprozesse die Überwachung prozessbestimmender Parameter notwendig ist. Andere Anwendungsgebiete sind unter den Stichworten "Ambient Intelligence" oder "Smart Factory" bekannt.

Die Sensorknoten eines Sensometzes können fest im Raum angeordnet sein, so dass sich die räumliche Zuordnung der gewonnen Messwerte aus der Position der Sensorknoten ergibt. Bewegen sich die Sensorknoten jedoch frei innerhalb der räumlichen Umgebungen, beispielsweise wenn diese in einer Flüssigkeit schweben oder schwimmen oder in schüttfähige Feststoffe eingebettet sind, so stellt sich das Problem, dass der Ort der Messwerterhebung unbekannt ist. Für eine sinnvolle Auswertung der Messwerte ist es daher notwendig, die räumliche Lage eines Sensorknotens zum Zeitpunkt der Messwerterhebung festzustellen.

Wichtige Randbedingungen für den praktischen Einsatz eines Systems zur Lokalisierung von Sensorknoten sind neben der für den jeweiligen Anwendungsfall hinreichenden Genauigkeit der Lagebestimmung eine umfassende Erhebung von Messdaten über den gesamten zu überwachenden Raum, eine hohe Zuverlässigkeit und damit Betriebssicherheit des Systems, eine größtmögliche Unempfindlichkeit gegenüber Störeinflüssen von außen, eine möglichst geringe Einflussnahme auf den verfahrenstechnischen Prozess durch die Positionsbestimmung, eine größtmögliche Flexibilität bei der Anpassung des Systems an eine bestehende Infrastruktur sowie eine Skalierbarkeit des Systems an produktionsspezifische Gegebenheiten. Zur Erzielung einer möglichst langen Einsatzdauer ist zudem die Minimierung der Verlustleistung in den Sensorknoten von großem Interesse.

Zur Lokalisierung von Sensorknoten sind unterschiedliche Verfahren bekannt. In gasförmiger Umgebung haben sich auf Funk basierende Verfahren bewährt, deren elektromagnetische Wellen jedoch in Medien mit hoher Dämpfung, wie zum Beispiel Flüssigkeiten, nur schlecht übertragen werden können. Unter solchen Bedingungen ist eine Lokalisierung nur durch Erhöhung der Sendeleistung möglich, was jedoch einen erhöhten Energieverbrauch mit sich bringt und Reflexionen an den Behälterwänden verstärkt. Der Einsatz von Ultraschall zur Lokalisierung ist aufgrund von Reflektionen an stählernen Behälterwänden, der Streuung in inhomogenen Medien und des relativ hohen Energieverbrauchs ebenfalls nur bedingt geeignet. Eine Lokalisierung mit Hilfe von Licht setzt wiederum voraus, dass die zu überwachenden Medien eine ausreichende Lichtdurchlässigkeit aufweisen, was in vielen Fällen nicht der Fall ist.

Darüber hinaus sind auch schon Verfahren bekannt, bei denen eine Positionsbestimmung auf Basis von Magnetfeldmessungen vorgenommen wird. So offenbart die DE 101 26 243 A1 eine Vorrichtung zur Positionsbestimmung mit einer triaxialen Spule zur Erzeugung eines Magnetfelds. Zur Positionsbestimmung werden Magnetfeldvektoren bestimmt, deren Betrag und Richtung für die rechnerische Positionsbestimmung zwingend notwendig sind. Entsprechend aufwändig und anwendungsspezifisch ist das dort beschrieben System.

### Darstellung der Erfindung:

Vor diesem Hintergrund besteht die Aufgabe der Erfindung darin, ein einfaches und wirkungsvolles System zur Ermittlung der Lage eines oder vieler Sensorknoten in einer räumlichen Umgebung bereit zu stellen, das für viele Anwendungsfälle gleichermaßen einsetzbar ist.

Diese Aufgabe wird durch ein Verfahren mit den Merkmalen des Patentanspruchs 1 und ein Verfahren mit den Merkmalen des Patentanspruchs 11 gelöst.

Vorteilhafte Weiterbildungen ergeben sich aus den Unteransprüchen.

Die Erfindung basiert auf dem Grundgedanken, die räumliche Position eines Sensorknotens aus dessen Abstand zu mindestens vier bekannten Raumpunkten zu ermitteln, wobei zur Abstandsbestimmung in den bekannten Raumpunkten magnetische Felder sequentiell erzeugt werden, aus deren jeweiliger Stärke im Aufenthaltsort des Sensorknotens sich der Abstand zwischen bekanntem Raumpunkt und Sensorknoten ableiten lässt. Dabei ist die Positionsbestimmung umso genauer, je mehr Abstandsbestimmungen zu bekannten Raumpunkten vorliegen.

Ein erster Vorteil der Erfindung ergibt sich aus der Verwendung von Magnetfeldern zur Positionsbestimmung. Diese durchdringen sowohl gasförmige als auch flüssige Medien und werden selbst von festen, nicht ferromagnetischen Stoffen nicht gestört. Damit erschließen sich der Erfindung Anwendungsfelder, die die eingangs beschriebenen Verfahren nicht oder nur unter Inkaufnahme von Nachteilen abdecken. Werden Sensorknoten beispielsweise in in Edelstahltanks abgefüllte Suspensionen oder Emulsionen eingesetzt, so beeinträchtigt die hohe Dämpfung der Flüssigkeit den Einsatz von auf Funk basierenden Lösungen. Die Verwendung von Licht zur Lokalisierung eines Sensorknotens wird durch dessen Schwächung und Reflektion an den Teilchen der dispersen Phase des Mediums beeinträchtigt. Schall als Informationsträger ist hingegen aufgrund der Reflektionen an der Behälterwand nicht möglich.

Prinzipiell kann das Magnetfeld im Sensorknoten erzeugt und die Messungen der Magnetfeldstärke außerhalb des Sensorknotens durchgeführt werden. Bevorzugt ist jedoch eine Ausführungsform der Erfindung bei der die Magnetfelder an bekanntem Ort und in gegenseitigem lichtem Abstand außerhalb der Sensorknoten erzeugt werden. Somit genügt es zur Positionsbestimmung die Stärke des Magnetfelds in den Sensorknoten zu messen, was vor allem hinsichtlich des Energiebedarfs der Sensorknoten entscheidende Vorteile bringt, da die für die Erzeugung des Magnetfelds notwendige Energie außerhalb der Sensorknoten benötigt wird und daher unkritisch von außen zugeführt werden kann. Hingegen kommen die Sensorknoten selbst mit minimaler Energie aus, was bestimmend für deren Lebensdauer ist. Ein geringer Energiebedarf ist aber auch Voraussetzung für eine Miniaturisierung der Sensorknoten, da eine im Verhältnis zum Behälter- bzw. Messvolumen geringe Größe der Sensorknoten erst deren Einsatz in großer Stückzahl erlaubt, ohne den Verfahrensprozess zu behindern.

Als weiterer Vorteil erweist sich bei außerhalb der Sensorknoten erzeugten Magnetfeldern, dass diese von mehreren Sensorknoten gleichzeitig ausgewertet werden können, ohne dass sich die Sensorknoten gegenseitig beeinflussen. Würden in jedem Sensorknoten Magnetfelder erzeugt werden, käme es zu einer gegenseitiger Überlagerung und dadurch fehlerbehafteter Positionsbestimmung. Die erfindungsgemäße Anordnung erlaubt daher die gleichzeitige Lokalisierung einer beliebigen Anzahl von Sensorknoten. Die daraus resultierende hohe Dichte an Messwerten erlaubt eine präzise Überwachung des Verfahrensprozesses. Die sich aus der Vielzahl von Sensorknoten ergebende Redundanz gewährleistet eine hohe Betriebssicherheit, selbst wenn nicht alle Sensorknoten brauchbare Messergebnisse liefern.

Die Möglichkeit des Einsatzes beliebig vieler Sensorknoten und der freien Bestimmung der Spulenparameter, der Spulenanordnung und der Stromstärke macht es möglich, die Erfindung an die vorhandenen Randbedingungen eines bestimmten Anwendungsfalls anzupassen. Damit ist ein Skalieren und Integrieren der Erfindung an eine vorgegebene Umgebung problemlos möglich, was auch ein Nachrüsten bestehender Anlagen mit dem erfindungsgemäßen System ermöglicht.

Im Unterschied zu den eingangs erwähnten Verfahren begnügt sich die Erfindung mit der betragsmäßigen Erfassung der Flussdichte im Sensorknoten. Die Bestimmung eines Magnetfeldvektors, der zudem die Richtung des Magnetfelds angibt, ist dabei nicht notwendig. Ein erfindungsgemäßes System zeichnet sich somit durch größere Einfachheit in der Konstruktion und Installation aus, das sich folglich vergleichsweise kostengünstig realisieren lässt. Trotzdem ermöglicht die Erfindung eine Lokalisierung der Sensorknoten mit hinreichender Genauigkeit für die meisten Anwendungsfälle, wobei das System sehr tolerant gegenüber Ungenauigkeiten bei der Installation oder Störeinflüssen von außen reagiert. Das vermindert den Aufwand bei der Installation eines erfindungsgemäßen Systems enorm und erhöht darüber hinaus die Funktionssicherheit erheblich, da die Betriebsbereitschaft auch bei anfänglicher oder nachträglicher Lageungenauigkeit der Spulen oder sonstiger Störeinflüsse gegeben ist.

### Kurze Beschreibung der Zeichnungen:

Die Erfindung wird nachstehend anhand eines in den Zeichnungen dargestellten Ausführungsbeispiels näher erläutert, aus dem weitere Merkmale und Vorteile der Erfindung offenbar werden. Das Ausführungsbeispiel stellt eine bevorzugte Umsetzung der Erfindung dar und ist daher nicht einschränkend zu verstehen. Vielmehr liegen auch abgewandelte und vereinfachte Ausführungsformen im Rahmen der Erfindung, auch wenn sie nicht ausdrücklich beschrieben sind.

Es zeigt
- Fig.1: eine schematische Darstellung einer erfindungsgemäße Vorrichtung zur Lokalisierung von Sensorknoten in einem Behältnis,
- Fig. 2: den zeitlichen Ablauf des sequentiellen ternären Schaltens der Spulen,
- Fig. 3: einen Schaltzyklus des in Fig. 2 dargestellten Ablaufs in vergrößerten Maßstab,
- Fig. 4: den Verlauf der Flussdichte eines Magnetfelds mit zunehmendem Abstand zum Spulenmittelpunkt entlang der Spulenhauptachse, und
- Fig. 5: eine schematische Darstellung des Verlaufs einer von einer Spule erzeugten Linie konstanter Flussdichte.

### Ausführliche Darstellung der Ausführungsbeispiele:

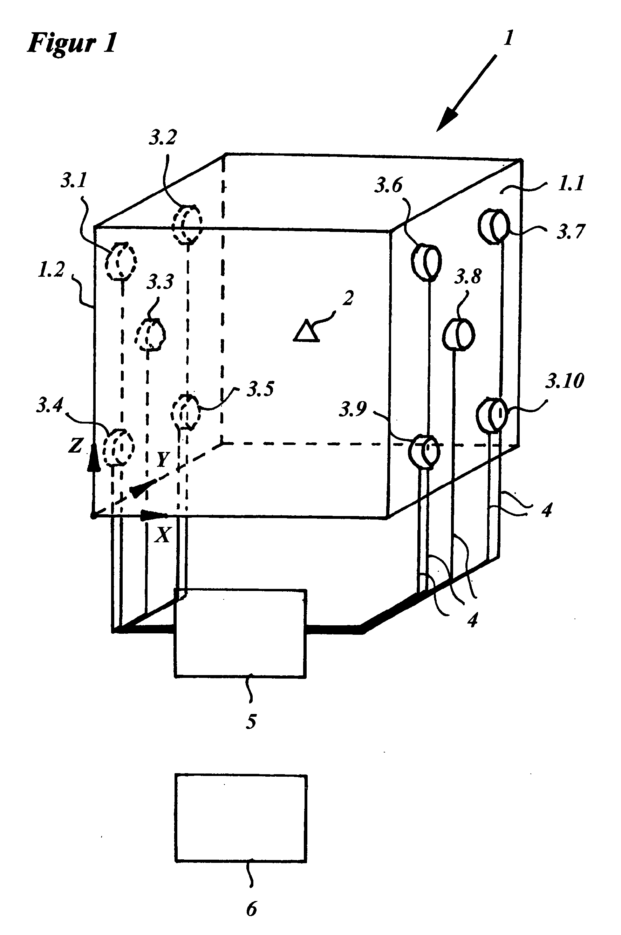

Fig. 1 zeigt einen allseits geschlossenen etwa kubischen Behälter 1 mit einer Vorderwand, einer Rückwand, den Seitenwänden 1.1 und 1.2 sowie einem Boden und Deckel. Die Kanten des Behälters 1 definieren die Achsen x, y und z eines kartesischen Koordinatensystems. Der Behälter 1 ist nicht an eine konkrete Größe oder Form gebunden und könnte ebenso eine zylindrische, konische oder sphärische Gestalt aufweisen. Der Behälter 1 besteht aus einem nicht ferromagnetischen Material, beispielsweise Edelstahl oder Kunststoff, wie es in der Lebensmittelindustrie häufig anzutreffen ist.

Der Behälter 1 ist Teil einer verfahrenstechnischen Anlage, in dem ein Medium einem Verfahrensprozess unterzogen wird, wozu der Behälter 1 ganz oder teilweise mit dem Medium befüllt ist. Zur Prozesssteuerung ist es notwenig die bestimmenden Prozessgrößen zu überwachen.

Beispielsweise kann es sich bei dem Behälter 1 um einen Gärtank für die Wein- oder Bierherstellung handeln, in dem der Most bzw. die Würze vergoren wird. Der Erfolg des Gärprozesses hängt von vielen Parametern ab, wie zum Beispiel der Temperatur, des Drucks, des Alkoholgehalts, des pH-Werts und dergleichen. Solche Gärtanks erreichen Höhen von über 20 m und Durchmesser von mehr als 6 m.

Zur Überwachung der erforderlichen Prozessgrößen befindet sich in dem Behälter 1 eine Vielzahl von Sensorknoten 2, von denen in Fig.1 lediglich einer stellvertretend dargestellt ist. Die Sensorknoten 2 können sich frei in der Flüssigkeit bewegen und sind mit geeigneten Sensoren zur Erfassung der Prozessgrößen ausgerüstet. Da die Prozessgrößen über das Behältervolumen variieren, ist es für die Auswertung der Prozessgrößen von großer Bedeutung, wo und gegebenenfalls wann diese erfasst worden sind.

Fig. 1 stellt darüber hinaus eine zur Lokalisierung der einzelnen Sensorknoten 2 geeignete erfindungsgemäße Vorrichtung dar. Die Vorrichtung umfasst eine Vielzahl von Spulen 3.1 bis 3.10, die in gegenseitigem lichtem Abstand gleichmäßig über die Außenseiten der beiden Seitenwände 1.3 und 1.4 verteilt sind. Dabei ist die Hauptachse der Spulen 3.1 bis 3.10 vorzugsweise orthogonal zu den Seitenwänden 1.3 und 1.4 ausgerichtet, wobei Winkelabweichungen von bis zu 20° die Genauigkeit der Positionsbestimmung nicht signifikant beeinträchtigen und gegebenenfalls rechnerisch berücksichtigt werden können. Die Spulen 3.1 bis 3.10 können unmittelbar an der Behälteraußenseite befestigt sein oder aber auch im Abstand dazu, um einem Übersteuern der Magnetfeldsensoren vorzubeugen. Die Spulenparameter wie Spulendurchmesser und -länge, Anzahl der Windungen etc. sind entsprechend den Rahmenbedingungen des jeweiligen Anwendungsfalls, wie zum Beispiel Größe und Form des Behälters 1 und Art des Mediums im Behälter 1, so zu wählen, dass in jedem möglichen Aufenthaltsort eines Sensorknotens 2 mindestens vier Magnetfelder, die auf unterschiedliche Spulen 3.1 bis 3.10 zurückgehen, in den Sensorknoten 2 gemessen werden können. Als vorteilhaft hat es sich erwiesen, die Spulen 3.1 bis 3.10 möglichst gleichmäßig in einheitlichem gegenseitigem Abstand über die Außenfläche des Behälters 1 zu verteilen. Im vorliegenden Fall beträgt der Spulendurchmesser 15 cm bei einer Spulenlänge von 2 cm und einer Windungsanzahl von 100. Der gegenseitige Abstand der Spulen 3.1 bis 3.10 beträgt zur möglichst vollständigen Abdeckung des Behältnisses 1 dem 2-fachen bis 20-fachen Spulendurchmesser, vorzugsweise dem 2-fachen bis 15-fachen Spulendurchmesser. Im vorliegenden Beispiel ist ein gegenseitiger Abstand von 100 cm gewählt. Andere Anwendungsfälle können zu davon abweichenden Werten führen.

Die Spulen 3.1 bis 3.10 sind jeweils über Leitungen 4 mit einer Stromversorgungs- und Steuereinheit 5 verbunden. Zur Verarbeitung der gewonnen Messwerte ist zudem eine Messwertverarbeitungseinheit 6 vorgesehen, die mit den Sensorknoten 2 drahtlos oder kabelgebunden kommuniziert.

Die Sensorknoten 2 stellen ein mikrosystemtechnisches Bauteil dar und umfassen neben Sensoren zur Erfassung der Prozessgrößen einen Sensor zur Messung der Flussdichte eines Magnetfelds, einen Signalverstärker, einen Mikrocontroller, ein Kommunikationsmodul, ein Speichermodul sowie eine Batterie zur Energieversorgung. Als Sensor zur Messung der Flussdichte eignen sich neben Flux- und Hall-Sensoren insbesondere magnetoresistive Sensoren, wie zum Beispiel AMR-Sensoren, die sich durch hohes Auflösungsvermögen und geringen Energieverbrauch auszeichnen. Der im vorliegenden Ausführungsbeispiel beschrieben magnetoresistive Sensor setzt sich aus drei AMR-Sensoren zusammen, die vorzugsweise orthogonal zueinander angeordnet sind, um die anteiligen Flussdichten in den Raumachsen jeweils zu erfassen. Damit lässt sich ein Messbereich von 2 nT bis 0,5 mT bei einer Auflösung von 2 nT erreichen.

Zur erfindungsgemäßen Lokalisierung der Sensorknoten 2 innerhalb des Behälters 1 bedarf es der folgenden Verfahrensschritte. Innerhalb eines Messzyklus werden zunächst die Spulen 3.1 bis 3.10 nacheinander geschaltet und zwar mit einer Stromstärke von 5 A. In einer sehr einfachen Ausführungsform des erfindungsgemäßen Verfahrens genügt es in jeder Spule 3.1 bis 3.10 jeweils durch kurzzeitige Schaltung ein Magnetfeld zu erzeugen, dessen Stärke vom Sensorknoten 2 erfasst wird. Bevorzugt ist jedoch eine Ausführungsform, bei der die Spulen 3.1 bis 3.10 sequentiell ternär geschaltet werden. Die Stärke des Magnetfelds im vorliegenden Beispiel übersteigt nicht 0,5 mT um ein Übersteuern der AMR-Sensoren zu vermeiden.

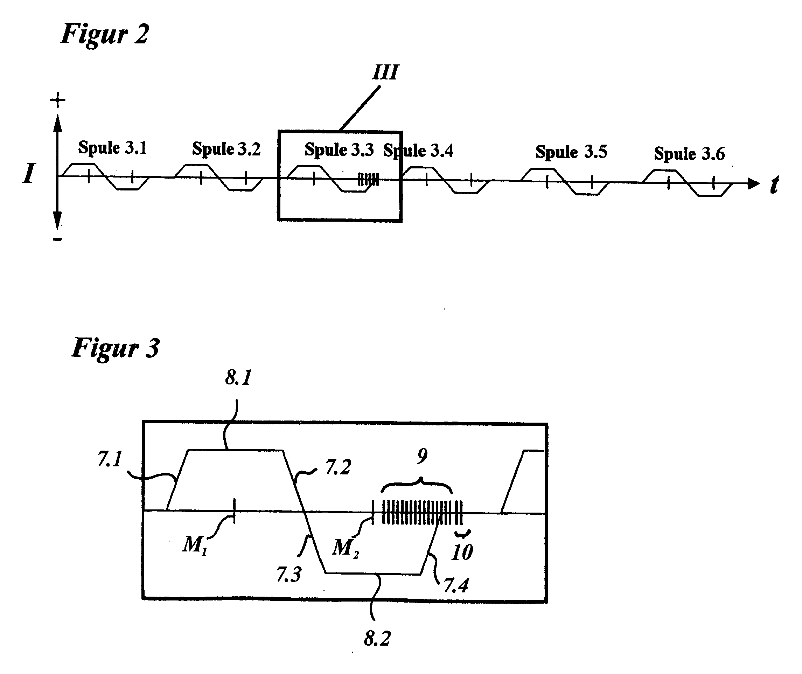

Fig. 2 zeigt ein sequentiell ternäres Schalten, bei dem jeder Schaltzyklus die Phasen "Bestromen der Spule in positiver Richtung", "Bestromen der Spule in negativer Richtung" und "Keine Bestromung" aufweist. Der Verlauf der Stromstärke in den Spulen 3.1 bis 3.10 ist in Fig. 2 wieder gegeben. Zu Beginn des Schaltphase "Bestromen der Spule in positiver Richtung" nimmt der Strom in der Spule 3.1 zu, was die ansteigende Flanke 7.1 verdeutlicht (Fig. 3). Während des sich anschließenden ersten Gleichstromplateaus bzw. quasi-Gleichstromplateaus 8.1 wird eine erste Messung M₁ des von der Spule 3.1 erzeugten Magnetfelds im Aufenthaltsort des Sensorknotens 2 durchgeführt. In der zweiten Schaltphase wird die Spule 3.1 in entgegengesetzter Richtung bestromt, was wiederum zu einem Übergang zu einem zweiten Gleichstromplateau bzw. quasi-Gleichstromplateau 8.2 führt. Den Übergang vom ersten Plateau 8.1 zum zweiten Plateau 8.2 beschreiben die Flanken 7. 2 und 7.3. Während des zweiten Gleichstromplateaus 8.2 wird eine zweite Messung M₂ der Stärke des Magnetfelds im Sensorknoten 2 ausgeführt. Während der dritten Schaltphase bleibt die Spule 3.1 ohne Bestromung, so dass der Strom in der Spule 3.1 entlang der Flanke 7.4 auf den Wert Null absinkt.

Die Messungen M₁ und M₂ der Stärke der Magnetfelder in den Sensorknoten 2 erfolgt mittels der triaxialen AMR-Sensoren, wobei während der beiden Gleichstromplateaus bzw. quasi-Gleichstromplateaus 8.1 und 8.2 jeweils die anteilige Flussdichte in den drei Raumrichtungen gemessen wird. Das ternäre Schalten der Spule 3.1 erlaubt dabei durch Subtraktion der anteiligen Flussdichten der zweiten Messung M₂ von denen der ersten Messung M₁ und anschließende Mittelwertbildung Störgrößen, die sich während der Messdauer nur langsam oder nicht ändern, wie zum Beispiel das Erdmagnetfeld, zu eliminieren. Aus den so bereinigten anteiligen Flussdichten kann jeweils durch Betragsbildung die absolute Flussdichte in einem Sensorknoten 2 errechnet werden. Eine hierzu alternative Vorgehensweise besteht im Flippen der Sensoren, was jedoch im Sensorknoten 2 geschehen muss und die dort nur begrenzt zur Verfügung stehende Energie verbraucht.

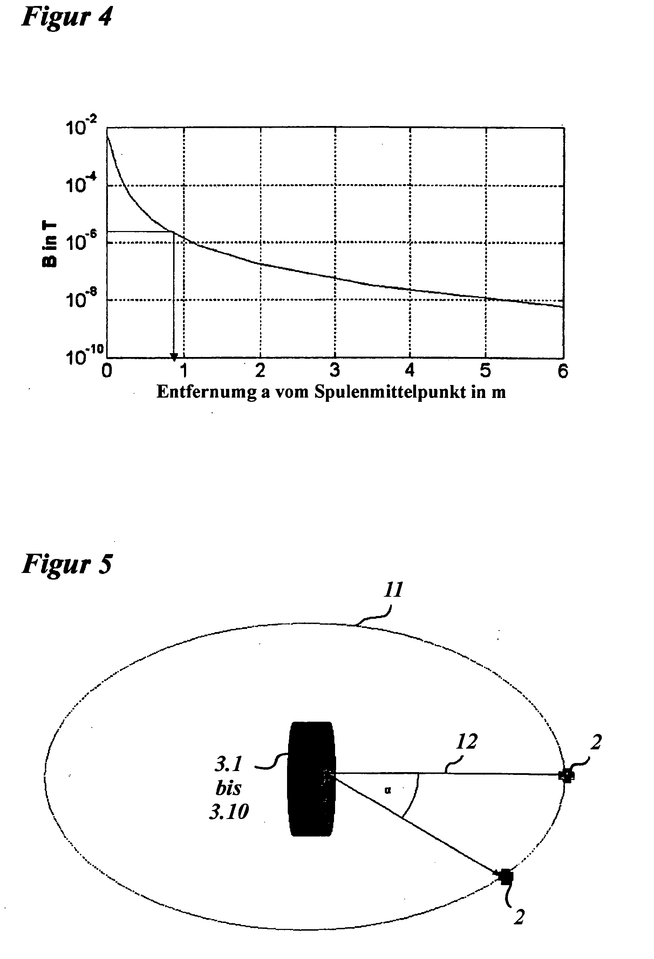

Aus der absoluten Flussdichte in den Sensorknoten 2 kann auf den Abstand der Sensorknoten 2 zu der Spule 3.1 geschlossen werden. Den Zusammenhang zwischen der Magnetfeldstärke in Spulenhauptachse und dem Abstand zur Magnetfeld erzeugenden Spule ist in Fig. 4 dargestellt. Erwartungsgemäß ist die Flussdichte im Spulenmittelpunkt am größten und nimmt mit zunehmender Entfernung in Richtung der Spulenhauptachse nach Art einer Hyperbel ab. Mit Hilfe des Biot-Savartschen Gesetzes lässt sich in Abhängigkeit der Spulen parameter der Abstand der Sensorknoten 2 von der Spule 3.1 bestimmen, wobei in einem ersten Schritt näherungsweise davon ausgegangen wird, dass sich die Sensorknoten 2 während der Messungen M₁ und M₂ auf Höhe der Hauptachse der Spule 3.1 befinden.

Durch sequentielles Schalten weiterer Spulen 3.2, 3.3, 3.4 usf. werden in entsprechender Weise weitere Abstände zwischen den Sensorknoten 2 und den Spulen 3.2, 3.3, 3.4 usf. ermittelt. Liegen mindestens vier Abstandswerte eines Sensorknotens 2 zu unterschiedlichen Spulen 3.1, 3.2, 3.3, 3.4 usf. vor, deren räumliche Lage wiederum bekannt ist, so kann mit Hilfe geeigneter Rechenalgorithmen die relative Lage der Sensorknoten 2 zu den Spulen 3.1, 3.2, 3.3, 3.4 usf. und damit die räumlichen Koordinaten der Sensorknoten 2 im Behälter 1 berechnet werden. Das in anderem Zusammenhang bekannte Sammon's Mapping hat sich bei der Bestimmung der Koordinaten der Sensorknoten 2 aus den Abständen zu vier bekannten Punkten als geeignet herausgestellt. Andere Verfahren sind die Triangulation, die Multilateration oder sonstige nicht lineare Mapping-Verfahren.

Der durch das sequentielle Schalten der unterschiedlichen Spulen 3.1, 3.2, 3.3, 3.4 etc bedingte zeitliche Versatz bei der Erzeugung der Magnetfelder und damit der Messungen der Flussdichten führt aufgrund der kurzen Schaltzyklen im Millisekundenbereich und der geringen Bewegung der Sensorknoten 2 im Behälter 1 zu keiner nennenswerten Beeinträchtigung des Lokalisierungsergebnisses.

Sollte die auf diese Weise erreichte Genauigkeit der Positionsbestimmung der Sensorknoten 2 nicht ausreichen, so kann durch iterative Berechnung berücksichtigt werden, dass die Linien gleicher Flussdichte eines von einer Spule 3.1 bis 3.10 erzeugten Magnetfelds ein Ellipsoid 11 ergeben, dessen Hauptachse mit der Spulenhauptachse 12 zusammenfällt. Figur 5 macht deutlich, dass die Flussdichte eines Magnetfelds nicht nur vom Abstand des Sensorknotens 2 zum Spulenmittelpunkt, sondern auch vom seitlichen Abstand zur Spulenhauptachse 12 abhängig ist. Dies führt immer dann zu Lokalisierungsfehlern, wenn sich ein Sensorknoten 2 während des Messvorgangs nicht auf Höhe der Spulenhauptachse 12 befindet, da die gemessene Flussdichte seitlich der Spulenhauptachse 12 auf einen geringeren Abstand zum Spulenmittelpunkt zurückgeht, so dass in diesem Fall die Annahme einer Flussdichtenmessung auf Höhe der Spulenhauptachse 12 zu einem größeren Abstand führt als tatsächlich vorhanden.

Gemäß der Erfindung ist daher vorgesehen diese anfänglichen Ungenauigkeiten durch iterative Berechnung der Sensorkoordinaten zu minimieren. Dabei stützen sich die Berechnungen zur Ermittlung der aktuellen Abstände eines Sensorknotens 2 zu den einzelnen Spulen 3.1 bis 3.10 auf dessen räumliche Lage, die in einem vorangegangenen Iterationsschritt berechnet worden ist. Durch erneutes Sammon's Mapping erfolgt dann eine verbesserte Positionsbestimmung, wobei im Zuge mehrmaliger Iteration die jeweils zuletzt ermittelte Position in Richtung der tatsächlichen Lage des Sensorknotens 2 konvergiert.

Ein erfindungsgemäßes Verfahren setzt voraus, dass das Zeitsystem der Spulen 3.1 bis 3.10 und das Zeitsystem der Sensorknoten 2 im Wesentlichen synchron laufen. In der Realität kann es aber durchaus zu einer Asynchronität der beiden Zeitsysteme kommen, da insbesondere im Zuge der Minimierung des Energieverbrauchs die Zeitzähler der Sensorknoten 2 eine größere Toleranz aufweisen. Die sich dabei im Laufe der Zeit kumulierende Zeitdifferenz zwischen den beiden Zeitsystemen würde ab einem bestimmten Ausmaß eine Lokalisierung der Sensorknoten 2 unmöglich machen. Gemäß der Erfindung ist daher eine Synchronisation der beiden Zeitsysteme vorgesehen.

Der Vorgang der Synchronisation ist in Fig. 3 näher dargestellt und erfolgt ebenfalls mit Hilfe der von den Spulen 3.1 bis 3.10 erzeugten Magnetfelder. Als Trigger für die Synchronisation dient die Differenz aus den beiden Gleichtromplateaus bzw. quasi-Gleichstromplateaus 8.1 und 8.2, deren Höhe im Zuge der Lokalisierung mit den Messungen M₁ und M₂ gewonnen wird. Erst bei ausreichend großer Differenz der beiden Messwerte werden fortlaufend Flussdichtemessungen 9 in den Sensorknoten 2 durchgeführt. Ein Differenzschwellenwert gewährleistet dabei eine ausreichend große Steigung der Flanke 7.4, so dass diese eindeutig für die Sensorknoten 2 identifizierbar ist und zur Synchronisation herangezogen werden kann. Als eindeutiges Identifizierungsmerkmal kann beispielsweise die starke Steigungsänderung am Anfang und Ende der Flanke 7.4 gedeutet werden oder aber die Abnahme auf ein definiertes Niveau des Gleichtromplateaus bzw. quasi-Gleichstromplateaus 8.2, beispielsweise auf einen Wert zwischen 80% und 20% des ursprünglichen Wertes. Die Messungen 10 der Prozessgrößen werden dann nach erfolgter Synchronisation ausgeführt.

## Patentansprüche

1. Verfahren zur Ermittlung der räumlichen Koordinaten x, y und z mindestens eines Sensorknoten (2) in einem Behältnis (1) mit folgenden Verfahrensschritten:
a) temporäres Erzeugen eines Magnetfelds der Stärke B_{S1} mit Hilfe einer Spule S₁ (3.1) im Zeitpunkt t₁, wobei die räumliche Lage der Spule S₁ (3.1) bekannt sind,
b) Ermittlung der Flussdichte B_{E1} am Aufenthaltsort des mindestens einen Sensorknotens (2) zum Zeitpunkt t₁ mittels Magnetfeldsensoren,
c) rechnerische Ermittlung der räumlichen Abstandswerte D₁ zwischen Sensorknoten (2) und Spule S₁ (3.1) aus der Flussdichte B_{E1} in dem mindestens einen Sensorknoten (2),
d) Wiederholen der Schritte a) bis c) mit jeweils weiteren voneinander räumlich beabstandeten Spulen S₁₊ᵢ (3.2 bis 3.10) zur Ermittlung der räumlichen Abstandswerte D₁₊ᵢ des mindestens einen Sensorknotens (2) zu den einzelnen Spulen S₁₊ᵢ, (3.2 bis 3.10) bis mindestens vier Abstandswerte D₁₊ᵢ vorliegen,
e) rechnerische Ermittelung der räumlichen Koordinaten x, y, z des mindestens einen Sensorknotens (2) aus den mindestens vier einzelnen Abstandswerten D₁₊ᵢ, wobei die lokalen Zeitsysteme in den Spulen (3.1 bis 3.10) und dem mindestens einen Sensorknoten (2) synchronisiert werden, **dadurch gekennzeichnet, dass** die Synchronisation auf Basis der von den Spulen (3.1 bis 3.10) erzeugten Magnetfelder und der in den Sensorknoten (2) gemessenen Magnetfelder erfolgt.

2. Verfahren nach Anspruch 1, **dadurch gekennzeichnet, dass** durch ternäres Schalten der einzelnen Spulen S₁₊ᵢ (3.1 bis 3.10) ein Wechsel der Richtung des Magnetfelds bewirkt wird.

3. Verfahren nach Anspruch 1 oder 2, **dadurch gekennzeichnet, dass** die Ermittlung der Flussdichten B_{E1+i} durch Betragsbildung der x-, y- und z-Anteile des Magnetfelds im Aufenthaltsort des mindestens einen Sensorknotens (2) erfolgt.

4. Verfahren nach einem der Ansprüche 1 bis 3, **dadurch gekennzeichnet, dass** Störgrößen, die sich während der Messdauer nur langsam oder nicht ändern, insbesondere das Erdmagnetfeld, bei der Ermittlung der Flussdichten B_{E1+i} in dem mindestens einen Sensorknoten (2) eliminiert werden.

5. Verfahren nach einem der Ansprüche 1 bis 4, **dadurch gekennzeichnet, dass** die einzelnen Abstandswerte D₁₊ᵢ mit Hilfe des Biot-Savart-Gesetzes ermittelt werden.

6. Verfahren nach einem der Ansprüche 1 bis 5, **dadurch gekennzeichnet, dass** die rechnerische Ermittlung der räumlichen Koordinaten x, y, z des mindestens einen Sensorknotens (2) aus den mindestens vier einzelnen Abstandswerten D₁₊ᵢ mittels abstandsbasierter Lokalisierungsalgorithmen erfolgt, insbesondere mittels Sammon's Mapping, Multilateration oder Triangulation.

7. Verfahren nach einem der Ansprüche 1 bis 6, **gekennzeichnet durch** Iteration der Verfahrensschritte c) bis e), wobei bei der Ermittlung der räumlichen Abstandswerte D₁ zwischen Sensorknoten (2) und Spule S₁ (3.1 bis 3.10) die im vorausgegangenen Iterationsschritt bestimmte relative räumliche Lage des mindestens einen Sensorknotens (2) zur Spule (3.1 bis 3.10) berücksichtigt wird.

8. Verfahren nach Anspruch 7, **dadurch gekennzeichnet, dass** als Trigger für das Synchronisationsverfahren der Verlauf der Stromstärke in den Spulen verwendet wird, wobei mit Überschreiten einer bestimmten Differenz aus den Gleichstromplateaus bzw. quasi-Gleichstromplateaus (8.1, 8.2) das Synchronisationsverfahren beginnt.

9. Verfahren nach Anspruch 8, **dadurch gekennzeichnet, dass** der Synchronisationszeitpunkt vom Verlauf einer an das erste oder zweite Gleichstromplateau bzw. quasi Gleichstromplateau (8.1, 8.2) anschließenden Flanke (7.1, 7.2, 7.3, 7.4) definiert wird.

10. Vorrichtung zur Ermittlung der räumlichen Koordinaten x, y und z mindestens eines Sensorknotens (2) in einem Behältnis (1)
- mit mindestens vier Spulen (3.1 bis 3.10) zur Erzeugung von mindestens vier Magnetfeldern in dem Behältnis (1), von denen jedes von einer unterschiedlichen Spule (3.1 bis 3.10) erzeugt ist,
- wobei die mindestens vier Spulen (3.1 bis 3.10) in gegenseitigem lichtem Abstand mit jeweils bekannter räumlicher Position im Bereich des Behältnisses (1) angeordnet sind,
- mit einer Stromversorgungs- und Steuereinheit (5) zum sequentiellen Schalten der mindestens vier Spulen (3.1 bis 3.10),
- mit Sensoren zur Erfassung der Stärke der mindestens vier unterschiedlichen Magnetfelder im Aufenthaltsort des Sensorknotens (2), und
- mit einer Messwertverarbeitungseinheit (6), die aus den einzelnen Flussdichten der mindestens vier unterschiedlichen Magnetfelder im Aufenthaltsort des mindestens einen Sensorknotens (2) jeweils den Abstand des mindestens einen Sensorknotens (2) zu jeder der mindestens vier Spulen (3.1 bis 3.10) ermittelt und aus den mindestens vier Abstandswerten des mindestens einen Sensorknotens (2) zu den mindestens vier Spulen (3.1 bis 3.10) die räumlichen Koordinaten des mindestens einen Sensorknotens (2) bestimmt, und
- mit Mittel zur Synchronisation der des Zeitsystems der Spulen (3.1 bis 3.10) und des Zeitsystems der Sensorknoten (2) auf Basis der von den Spulen (3.1 bis 3.10) erzeugten Magnetfelder und der in den Sensorknoten (2) gemessenen Magnetfelder.

11. Vorrichtung nach Anspruch 10, **dadurch gekennzeichnet, dass** jedes der mindestens vier Magnetfelder ein Stärke von mindestens 0,5 mT aufweist.

12. Vorrichtung nach Anspruch 10 oder 11, **dadurch gekennzeichnet, dass** der gegenseitige Abstand der mindestens vier Spulen (3.1 bis 3.10) zwischen dem 2-fachen bis 20-fachen des Spulendurchmessers liegt, vorzugsweise zwischen dem 2-fachen bis 15-fachen.

13. Vorrichtung nach einem der Ansprüche 10 bis 12, **dadurch gekennzeichnet, dass** die mindestens vier Spulen (3.1 bis 3.10) im lichten Abstand zur Wand des Behältnisses (1) angeordnet sind.

14. Vorrichtung nach einem der Ansprüche 10 bis 13, **dadurch gekennzeichnet, dass** der mindestens eine Sensorknoten (2) magnetoresistive Sensoren zur Flussdichtemessung aufweist, vorzugsweise AMR-Sensoren, die vorzugsweise orthogonal ausgerichtet sind.

## Claims

1. Method for determining the spatial coordinates x, y and z of at least one sensor node (2) in a container (1), comprising the following steps:
a) temporarily generating a magnetic field with the strength B_{S1} by means of a coil S₁ (3.1) at the time t₁, the spatial position of the coil S₁ (3.1) being known,
b) determining the flux density B_{E1} at the location of the at least one sensor node (2) at the time t₁ by means of magnetic field sensors,
c) calculating the spatial distance values D₁ between the sensor node (2) and coil S₁ (3.1) from the flux density B_{E1} in the at least one sensor node (2),
d) repeating steps a) to c) with additional coils S₁₊ₗ (3.2 to 3.10), which in each case are spaced apart from one another, in order to determine the spatial distance values D₁₊ₗ of the at least one sensor node (2) from the individual coils S₁₊ₗ (3.2 to 3.10) until there are at least four distance values D₁₊ₗ,
e) calculating spatial coordinates x, y, z of the at least one sensor node (2) from the at least four individual distance values D₁₊ₗ, the local time systems in the coils (3.1 and 3.10) and the at least one sensor node (2) being synchronised, **characterised in that** the synchronisation is carried out on the basis of the magnetic fields generated by the coils (3.1 and 3.10) and the magnetic fields measured in the sensor nodes (2).

2. Method according to claim 1, **characterised in that** the direction of the magnetic field is changed by ternary switching of the individual coils S₁₊ₗ (3.1 to 3.10).

3. Method according to either claim 1 or claim 2, **characterised in that** the flux densities B_{E1+l} are determined by establishing the size of the x, y and z proportions of the magnetic field at the location of the at least one sensor node (2).

4. Method according to any of claims 1 to 3, **characterised in that** disturbances that only slowly change during the measurement period or that do not change at all, in particular the terrestrial magnetic field, are eliminated when the flux densities B_{E1+l} in the at least one sensor node (2) are determined.

5. Method according to any of claims 1 to 4, **characterised in that** the individual distance values D₁₊ₗ are determined by means of Biot-Savart's law.

6. Method according to any of claims 1 to 5, **characterised in that** the spatial coordinates x, y, z of the at least one sensor node (2) are calculated from the at least four individual distance values D₁₊ₗ by means of distance-based positioning algorithms, in particular Sammon's mapping, multilateration or triangulation.

7. Method according to any of claims 1 to 6, **characterised by** iteration of steps c) to e), the relative spatial position, ascertained in the previous iteration step, of the at least one sensor node (2) with respect to the coil (3.1 to 3.10) being taken into account when determining the spatial distance values D₁ between the sensor node (2) and the coil S₁ (3.1 to 3.10).

8. Method according to claim 7, **characterised in that** the development of the current intensity in the coils is used as the trigger for the synchronisation process, the synchronisation process starting when a certain difference from the direct current plateaus or virtual direct current plateaus (8.1, 8.2) is exceeded.

9. Method according to claim 8, **characterised in that** the synchronisation point is defined from the course of a slope (7.1, 7.2, 7.3, 7.4) which follows the first or second direct current plateau or virtual direct current plateau (8.1, 8.2).

10. Device for determining the spatial coordinates x, y and z of at least one sensor node (2) in a container (1)
- comprising at least four coils (3.1 to 3.10) for generating at least four magnetic fields in the container (1), each of which is generated by a different coil (3.1 to 3.10),
- the at least four coils (3.1 to 3.10) being arranged in the region of the container (1) at a clear distance from one another and in a spatial position that is known in each case,
- comprising a power supply and control unit (5) for sequentially switching the at least four coils (3.1 to 3.10),
- sensors for detecting the intensity of the at least four different magnetic fields at the location of the sensor node (2), and
- a measured value processing unit (6) which in each case determines the distance of the at least one sensor node (2) from each of the at least four coils (3.1 to 3.10) from the individual flux densities of the at least four different magnetic fields at the location of the at least one sensor node (2) and which ascertains the spatial coordinates of the at least one sensor node (2) from the at least four distance values of the at least one sensor node (2) from the at least four coils (3.1 to 3.10), and
- a means for synchronising the time system(s) of the coils (3.1 to 3.10) and the time system of the sensor nodes (2) on the basis of the magnetic fields generated by the coils (3.1 to 3.10) and the magnetic fields measured in the sensor nodes (2).

11. Device according to claim 10, **characterised in that** each of the at least four magnetic fields has an intensity of at least 0.5 mT.

12. Device according to either claim 10 or claim 11, **characterised in that** the mutual distance between the at least four coils (3.1 to 3.10) is between two times and 20 times the diameter of the coils, preferably between two times and 15 times.

13. Device according to any of claims 10 to 12, **characterised in that** the at least four coils (3.1 and 3.10) are arranged at a clear distance from the wall of the container (1).

14. Device according to any of claims 10 to 13, **characterised in that** the at least one sensor node (2) has magnetoresistive sensors for measuring flux densities, preferably AMR sensors, which are preferably orientated orthogonally.

## Revendications

1. Procédé pour déterminer les coordonnées spatiales x, y et z d'au moins un noeud capteur (2) dans un contenant (1) et comportant les étapes suivantes :
a) génération temporaire d'un champ magnétique d'intensité B_{S1} à l'aide d'une bobine S₁ (3.1) à l'instant t₁, la position spatiale de la bobine S₁ (3.1) étant connue,
b) détermination de la densité de flux B_{E1} au lieu de séjour dudit au moins un noeud capteur (2) à l'instant t₁ au moyen de capteurs de champ magnétique,
c) calcul des valeurs de distance spatiale D₁ entre noeud capteur (2) et bobine S₁ (3.1) à partir de la densité de flux B_{E1} dans ledit au moins un noeud capteur (2),
d) répétition des étapes a) à c) avec d'autres bobines S₁₊ᵢ (3.2 à 3.10) espacées les unes des autres pour déterminer les valeurs de distance spatiale D₁₊ᵢ dudit au moins un noeud capteur (2) par rapport aux différentes bobines S₁₊ᵢ (3.2 à 3.10) jusqu'à l'obtention d'au moins quatre valeurs de distance D₁₊ᵢ,
e) calcul des coordonnées spatiales x, y, z dudit au moins un noeud capteur (2) à partir desdites au moins quatre différentes valeurs de distance D₁₊ᵢ, les systèmes de temps locaux dans les bobines (3.1 à 3.10) et ledit au moins un noeud capteur (2) étant synchronisés, **caractérisé en ce que** la synchronisation est effectuée sur la base des champs magnétiques générés par les bobines (3.1 à 3.10) et des champs magnétiques mesurés dans les noeuds capteurs (2).

2. Procédé selon la revendication 1, **caractérisé en ce qu'**un changement de direction du champ magnétique est produit par commutation ternaire des différentes bobines S₁₊ᵢ (3.1 à 3.10).

3. Procédé selon la revendication 1 ou 2, **caractérisé en ce que** la détermination des densités de flux B_{E1+i} est réalisée par formation de valeur absolue des composantes x, y et z du champ magnétique au lieu de séjour dudit au moins un noeud capteur (2).

4. Procédé selon l'une des revendications 1 à 3, **caractérisé en ce que** les grandeurs perturbatrices qui ne varient que lentement ou pas du tout pendant la durée de mesure, en particulier le champ magnétique terrestre, sont éliminées lors de la détermination des densités de flux B_{E1+i} dans ledit au moins un noeud capteur (2).

5. Procédé selon l'une des revendications 1 à 4, **caractérisé en ce que** les différentes valeurs de distance D₁₊ᵢ sont déterminées à l'aide de la loi de Biot et Savart.

6. Procédé selon l'une des revendications 1 à 5, **caractérisé en ce que** le calcul des coordonnées spatiales x, y, z dudit au moins un noeud capteur (2) à partir desdites au moins quatre différentes valeurs de distance D₁₊ᵢ est effectué au moyen d'algorithmes de localisation basés sur la distance, en particulier par projection non linéaire de Sammon, multilatération ou triangulation.

7. Procédé selon l'une des revendications 1 à 6, **caractérisé par** l'itération des étapes de procédé c) à e), la position spatiale relative dudit au moins un noeud capteur (2) par rapport à la bobine (3.1 à 3.10) déterminée lors du pas d'itération précédent étant prise en compte lors de la détermination des valeurs de distance spatiale D₁ entre noeud capteur (2) et bobine S₁ (3.1 à 3.10).

8. Procédé selon la revendication 7, **caractérisé en ce que** l'on utilise la forme de l'intensité du courant dans les bobines comme déclencheur du procédé de synchronisation, le procédé de synchronisation commençant avec le dépassement d'une différence définie entre les plateaux de courant continu ou les plateaux de courant quasi continu (8.1, 8.2).

9. Procédé selon la revendication 8, **caractérisé en ce que** l'instant de synchronisation est défini par la forme d'un flanc (7.1, 7.2, 7.3, 7.4) faisant suite au premier ou au deuxième plateau de courant continu ou plateau de courant quasi continu (8.1, 8.2).

10. Dispositif pour déterminer les coordonnées spatiales x, y et z d'au moins un noeud capteur (2) dans un contenant (1)
- avec au moins quatre bobines (3.1 à 3.10) pour générer au moins quatre champs magnétiques dans le contenant (1), chacun d'entre eux étant généré par une bobine différente (3.1 à 3.10),
- lesdites au moins quatre bobines (3.1 à 3.10) étant disposées à une distance libre mutuelle, chaque fois à une position spatiale connue dans la zone du contenant (1),
- avec une unité d'alimentation électrique et de commande (5) pour la commutation séquentielle desdites au moins quatre bobines (3.1 à 3.10),
- avec des capteurs pour détecter l'intensité desdits au moins quatre champs magnétiques différents au lieu de séjour du noeud capteur (2), et
- avec une unité de traitement de valeurs mesurées (6), qui détermine, à partir des différentes densités de flux desdits au moins quatre champs magnétiques différents au lieu de séjour dudit au moins un noeud capteur (2), la distance dudit au moins un noeud capteur (2) par rapport à chacune desdites au moins quatre bobines (3.1 à 3.10) et détermine les coordonnées spatiales dudit au moins un noeud capteur (2) à partir desdites au moins quatre valeurs de distance dudit au moins un noeud capteur (2) par rapport auxdites au moins quatre bobines (3.1 à 3.10), et
- avec des moyens pour synchroniser le système de temps des bobines (3.1 à 3.10) et le système de temps des noeuds capteurs (2) sur la base des champs magnétiques générés par les bobines (3.1 à 3.10) et des champs magnétiques mesurés dans les noeuds capteurs (2).

11. Dispositif selon la revendication 10, **caractérisé en ce que** chacun desdits au moins quatre champs magnétiques présente une intensité d'au moins 0,5 mT.

12. Dispositif selon la revendication 10 ou 11, **caractérisé en ce que** la distance mutuelle desdites au moins quatre bobines (3.1 à 3.10) est comprise entre 2 et 20 fois, de préférence entre 2 et 15 fois, le diamètre de bobine.

13. Dispositif selon l'une des revendications 10 à 12, **caractérisé en ce que** lesdites au moins quatre bobines (3.1 à 3.10) sont disposées à une distance libre par rapport à la paroi du contenant (1).

14. Dispositif selon l'une des revendications 10 à 13, **caractérisé en ce que** ledit au moins un noeud capteur (2) présente des capteurs magnétorésistifs pour la mesure de la densité de flux, de préférence des capteurs AMR qui sont de préférence orientés orthogonalement.
